# EUROPEAN PATENT APPLICATION

(11) **EP 3 217 335 A1**
(43) Date of publication of application: **13.09.2017**
(21) Application number: 17160298.0
(22) Date of filing: 10.03.2017
(51) Int. Cl.: G06N 7/00

(54) **METHOD AND SYSTEM FOR GENERATING A TRAINING MODEL FOR FABRICATING SYNTHETIC DATA AND FOR FABRICATING SYNTHETIC DATA**

(30) Priority: 11.03.2016 EP 16159981
(71) Applicant: Deutsche Telekom AG, 53113 Bonn (DE)
(72) Inventor: SWAMINATHAN, Rahul, 10435 Berlin (DE)
(74) Representative: Vossius & Partner Patentanwälte Rechtsanwälte mbB

(57) **Abstract**

The invention relates to a method for generating a training model for fabricating synthetic data comprising the steps of: providing training data comprising information on a plurality of objects, the training data further comprising information on a plurality of states and state transitions of at least one object of the plurality of objects, the state transitions of the at least one object being timely ordered into a plurality of sessions; clustering a plurality of states and/or a plurality of state clusters into a plurality of state transition clusters; clustering the sessions of respective state transitions clusters into a plurality of session clusters; modeling each session cluster using a stochastic process; and training a probabilistic model using information on the respective object, the corresponding session clusters, start times of the corresponding sessions of the session cluster, the end times of the corresponding sessions of the session cluster and the delays between the corresponding session clusters.

## Description

The present invention relates to a method and a system for generating a training model for fabricating synthetic data. The present invention also relates to a method and system for fabricating synthetic data. The present invention also relates to a corresponding computer-readable medium containing program to perform any of the presented methods.

A gist of the present invention is the modeling of real data for the purpose of synthesis of statistically similar data. One of the purposes of data synthesis is to create secure and privacy compliant randomized data that retains most of the statistical nuances of the original real data. The challenge to achieving this lies in modeling real data without any end use-case in mind.

In the general setting, this is an ill-posed problem and has no solution that models all relationships within the data automatically, due to the combinatorial complexity in detecting and modeling. The present invention offers, among others, a tractable and efficient solution for certain domains of data and analytics.

A direct consequence of this is that the present invention is not restricted to any specific use case for which we model data. The present invention provides a generic means for someone knowledgeable in the semantics of the data to map it into a machine readable format that allows for automatic modeling and synthesis.

It is an object of the invention to provide a method and a system for generating a training model for fabricating synthetic data. It is another object of the present invention to provide a method and system for fabricating synthetic data. It is another object of the present invention to provide a corresponding computer-readable medium containing program to perform any of the aforementioned methods.

The method according to the present invention is computer-implemented. However, it is understood by the skilled person that there are also other ways of implementing the method according to the present invention.

This object is achieved by a method and a system according to the independent claims. Dependent patent claims refer to preferred embodiments.

The invention relates to a method for generating a training model for fabricating synthetic data comprising the steps of:
a) providing training data comprising information on a plurality of objects, the training data further comprising information on a plurality of states and state transitions of at least one object of the plurality of objects, the state transitions of the at least one object being chronologically ordered into a plurality of sessions;
b) clustering a plurality of states and/or a plurality of state clusters into a plurality of state transition clusters;
c) clustering the sessions of respective state transitions clusters into a plurality of session clusters;
d) modeling each session cluster using a stochastic process; and
e) training a probabilistic model using information on the respective object, the corresponding session clusters, start times of the corresponding sessions of the session cluster, the end times of the corresponding sessions of the session cluster and the delays between the corresponding session clusters.

Preferably, the method further comprises: clustering a plurality of states of respective objects into a plurality of state clusters after step a) and clustering the plurality of state clusters into a plurality of state transition clusters.

Preferably, the stochastic process in step d) comprises a Markov Chain.

Preferably, the probabilistic model in step e) comprises a Bayesian Network tm.

Preferably, the method further comprises at least one of the following steps before step a):
- removing empty data and/or removing outlier data from the training data;
- allocating a unique identifier OID to each object;
- allocating a unique identifier TID to each state transition;
- splitting at least one timely ordered sequence of state transitions into a plurality of sessions.

Preferably, at least one constraint is introduced into the probabilistic model.

Preferably, the clustering of the sessions of respective state transitions clusters into a plurality of session clusters in step d) is performed using the Fréchet-Distance to measure the distance between sessions.

Preferably, the clustering of the sessions of respective state transitions clusters into a plurality of session clusters in step d) is performed using the word2vec tool (see references [1] and [2]).

Preferably, at least one node of the Markov Chain represents a corresponding state transition cluster.

Preferably, the at least one node is linked to a further Bayesian Network for training to predict at least one item of the respective state transition cluster.

Preferably, the at least one node is linked to a further Bayesian Network dl for training to predict the delay time until the subsequent state transition following the corresponding state transition cluster is performed.

Preferably, at least one constraint is introduced into the stochastic process.

Preferably, the clustering of the plurality of states of respective objects into a plurality of state clusters is performed using vector quantization, preferably using a k-means heuristic, more preferably using a k-means heuristic with Euclidian distance as a distance measure.

Preferably, the clustering of the plurality of state clusters into a plurality of state transition clusters is performed using vector quantization, preferably using a k-means heuristic, more preferably using a k-means heuristic with Euclidian distance as a distance measure.

The invention also relates to a method for fabricating synthetic data comprising any of the aforementioned methods.

Preferably, the method for fabricating synthetic data comprises the following steps:
a) loading the trained probabilistic model;
b) inputting the number of sessions to be fabricated;
c) creating a table using a Bayesian Network, comprising at least one of the following information:
   number and identity of objects in the respective cluster session;
   start time and/or end time of the respective cluster session; and
d) loading the stochastic process for every object in every cluster session.

The invention also relates to a system for generating a training model for fabricating synthetic data using any of the aforementioned methods for generating a training model for fabricating synthetic data.

The invention also relates to a system for fabricating synthetic data using any of the aforementioned methods for fabricating synthetic data.

The invention also relates to a computer-readable medium containing program instructions for causing a computer to perform any of the aforementioned methods.

The present invention has, among others, the following advantages:
- Flexible modeling of state transition based synthetic data ranging from movement data as well as data over time of specific objects/items/individual processes, etc.
- Capability to model interdependencies modeled as a Bayesian network wherein every relationship of dependencies and independencies are statistically modeled.
- Such modeling of both numeric as well as categorical data allows for statistical sampling from distributions as well as linear and non-linear regression (or other non linear modeling approach based) fitting and synthesis.
- Multi-level clustering allows for grouping of similar behaviour patterns at various levels allowing for better modeling and compression of models while further preserving privacy.
- Synthesis and modeling are two sides of the same coin, a clear idea of what can be modeled is therefore possible as well as clear metric of goodness of the generated data.
- Synthesis is performed by randomly sampling amongst clustered models and then using the composition of Markov chains and Bayesian networks to completely generate sets of records that follow the distributions and models computed before.

The present invention will be described in even greater detail below based on the exemplary figures. The invention is not limited to the exemplary embodiments. All features described and/or illustrated herein can be used alone or combined in different combinations in embodiments of the invention. The features and advantages of various embodiments of the present invention will become apparent by reading the following detailed description with reference to the attached drawings which illustrate the following:
Figure 1 shows creating a training model for fabricating synthetic data according to an embodiment of the present invention.
Figure 2 shows state transitions modeled in a 4-level hierarchy according to an embodiment of the present invention.
Figure 3 shows an exemplary sketch of single location clustering according to an embodiment of the present invention.
Figure 4 shows connected Transaction clusters according to an embodiment of the present invention.
Figure 5 shows an exemplary sketch of session clustering according to an embodiment of the present invention.
Figure 6 shows an exemplary sketch of clustering the sessions of respective state transitions clusters into a plurality of session clusters using the word2vec tool according to an embodiment of the present invention.
Figure 7 shows an exemplary sketch of clustering the sessions of respective state transitions clusters into a plurality of session clusters using the Fréchet-Distance to measure the distance between sessions according to an embodiment of the present invention.
Figure 8 shows an exemplary sketch of clustering the sessions of respective state transitions clusters into a plurality of session clusters using the "histogram"-approach according to an embodiment of the present invention.
Figure 9 shows an exemplary sketch of a Markov Chain Model for a single session cluster according to an embodiment of the present invention.
Figure 10 shows an exemplary sketch of the general concept of sequence modelling according to an embodiment of the present invention.
Figure 11 shows an exemplary sketch of the synthesis loop for ObjectID = 1 according to an embodiment of the present invention.
Figure 12 shows an exemplary sketch of fabricating synthetic data according to the learned model according to an embodiment of the present invention.
Figure 13 shows a visualization of pickup and drop-off locations according to an embodiment of the present invention.
Figure 14 shows an exemplary sketch of Call Data Recordings according to an embodiment of the present invention.
Figure 15 shows a used input file for an algorithm according to an embodiment of the present invention.
Figure 16 shows some results of comparison of real clustered data and synthesized data according to an embodiment of the present invention.
Figures 17a and 17b show comparing the pickup times of the real and synthesized data an almost equal period could be achieved according to an embodiment of the present invention.
Figures 18a and 18b show the relationship between Distance and Costs in both data sets according to an embodiment of the present invention.
Figures 19a and 19b show the relationship between Distance and Tip according to an embodiment of the present invention.
Figure 20 shows an extract of a used data structure of Call Data Recordings as input for an algorithm according to an embodiment of the present invention.
Figures 21a and 21b show the number of CDR events in time divided by SMS type for real data and synthetic data according to an embodiment of the present invention.
Figures 22a and 22b show comparing the synthesis and real data regarding the ObjectID according to an embodiment of the present invention.
Figures 23 a and 23b show the differences of the SMS type divided by Gender and AgeGroup for real data and synthetic data according to an embodiment of the present invention.
Figure 24 shows the distribution of the age groups within the real and synthetic data according to an embodiment of the present invention.
Figure 25 shows that considering Gender in the synthetic data, the relative amount throughout all transactions is comparable with the relative amounts within the real data according to an embodiment of the present invention.
Figure 26 shows a summarization of challenges during the development of the present invention.
Figure 27 shows an elbow diagram for finding the right k in the clustering algorithm "k-means" according to an embodiment of the present invention.

The present invention relates to modeling and synthesizing datasets that contain certain salient features such as an ObjectID that can be followed over time, and wherein records essentially can be said to describe "Transactions" or state-transitions and have associated variables (called "Items") that are dependent on the Transaction.

One example of such a dataset is the movement data ranging from taxi trips including the Object ID denoting the driver. Thus, every trip the driver makes can be seen as a "Transaction" from one location (state) to another (state). And all the associated data which is collected such as distance, cost, tip, time etc., all relate to the Transaction (trip) being performed.

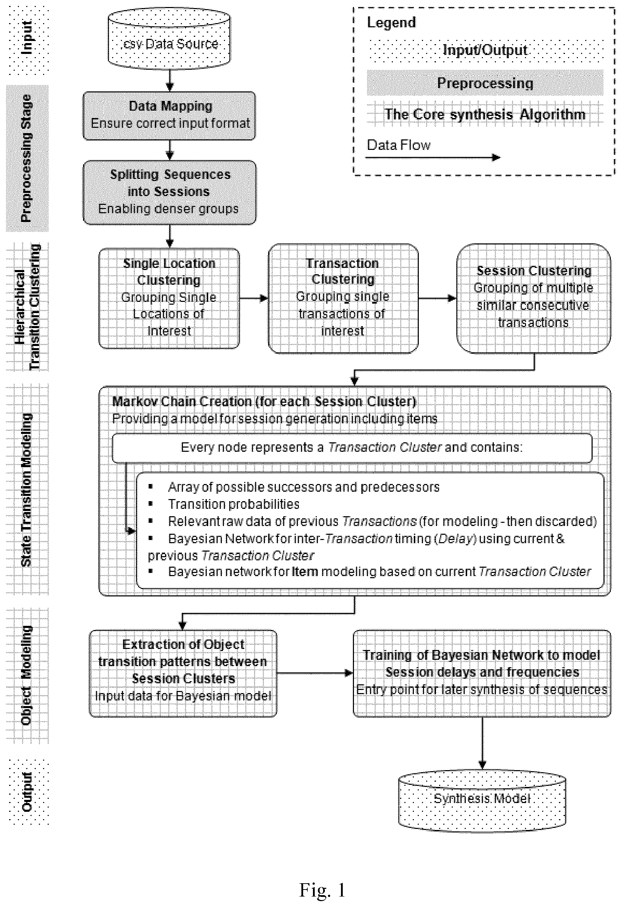

Similarly, the method extends to other motion datasets including long haul train and bus networks as well as cellular and data networks. The current implementation supports two types of main functionalities:
(1) Creating a new model for a given data source as can be seen in Figure 1. This process trains a new model from scratch according to the introduced data. The resulting model contains various sub models, each containing compressed probabilistic aspects of the real input data, needed for generating new synthetic data that resembles real behaviour. After the model creation process, the original data is discarded.

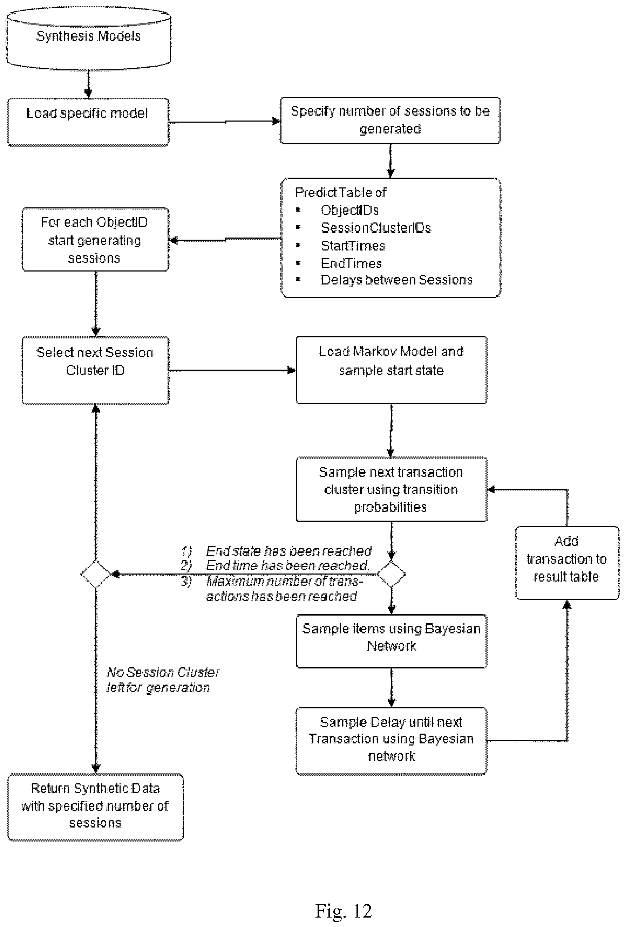

According to this embodiment, the model creation process basically comprises five steps:
- Input Data: Defining and loading the data, preferably as a .csv.
- Data Mapping: Transforming data into a format most suitable for the modeling phase.
- Hierarchical Transition Clustering: Multilevel data compression using clustering, to "carve out" core aspects of real movements.
- State Transition Model Building: Modeling of influencing factors that lead to certain movement patterns as well as the modeling of the various Transaction dependent variables is performed using a system of Markov Chains and Bayesian networks.
- Object Modeling: The various objects are modelled based on their distribution of Sessions and time intervals between Sessions.
- Persistent Model Creation: Saving the complete modeling results (the prototypical implementation used so called R-Objects, which are a single R-File containing all information and objects created in the model creation phase.
   (2) Fabricating synthetic data according to the learned model as can be seen in Figure 12. This process synthesizes new data by applying Random Walk procedures on the trained models. The fabrication process is a parallel and iterative process.

### Input Data and Data Mapping

In order to distinguish between the different data fields and maintain a generic structure, each data source needs to be mapped against the generic input structure needed by the system.

This task is performed by a Data Mapper in a pre-processing step, as will be discussed below, individually designed and configured for different input data.

As stated earlier, the present invention is capable of modeling the state transition behaviour of multiple objects within the data set.

In this embodiment, the manner in which the class of data sets for which the algorithm works is defined is that the data set comprises one or more ObjectIDs that are consistent or persistent throughout the dataset and whose behaviour is of interest within the dataset.

This ObjectID could represent an individual (anonymized) or an item such as a movie, etc. Furthermore, the object performs various transactions that include various state transitions. Preferably, the number of states that denote a transaction is some constant greater than or equal to 1 and valid for all Transactions within the data set. Each Transaction has therefore a Start Time and the elapsed time between one state and the next within the Transactions are denoted by the term "Duration".

Thus for example, of a taxi trip being a Transaction, the starting location and destination represent two states and the time between the start and the end of the state as duration.

Preferably, when the Transaction is a single state based action, then Duration can be assumed to be zero if not otherwise stated.

Preferably, the states of a Transaction are denoted as Cartesian coordinates. However, according to other embodiments, the states can be extended easily to categorical data too.

### Algorithm flow

The algorithm progresses by tracking the Transaction of each object ID in terms of Sequence, Sessions, Transactions and States in the following manner.

A Sequence is defined as the complete list of "Transactions" or all possible records per unique ObjectID.

The Sequence is then split into a plurality of Sessions. According to other embodiments, a Session can be considered as a sequence of closely timed Transactions separated by other Sessions with a long temporal pause.

Object behaviour is modeled by first hierarchically clustering the various Sequences and component Sessions.

One of the advantages of breaking Sequences into Sessions is that they could be very long and thereby hinder any reasonable attempt at clustering similar Sequences.

The Sessions themselves are made up of individual Transactions. Every Transaction comprises an ObjectID making some set of state transitions each of which takes some time (Duration) and has related variables (Items).

In order to group similar Sessions together, preferably using k-means, we first group Transactions together following the hierarchical clustering paradigm to bottom up reduce the number of data elements being worked with and find more compact representations of them. Therefore, the following fields can be handled; some are mandatory and some are optional fields according to this embodiment:

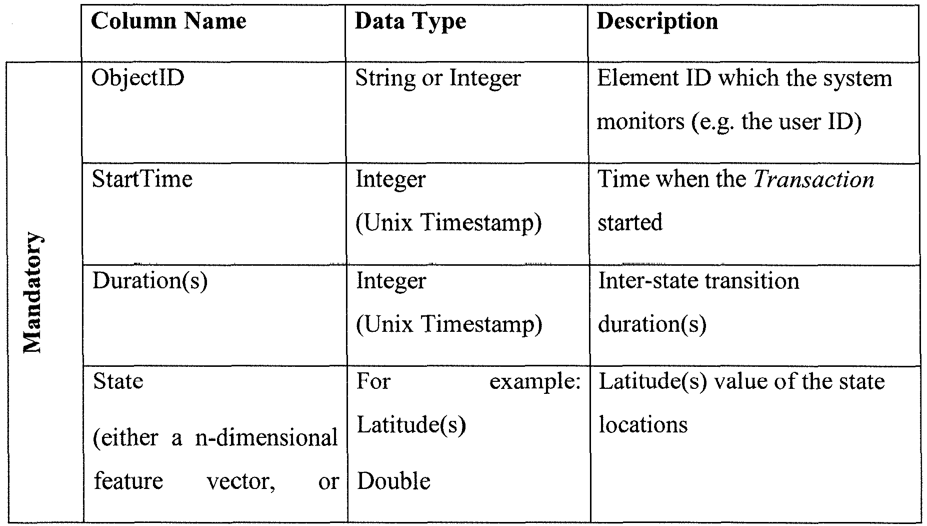

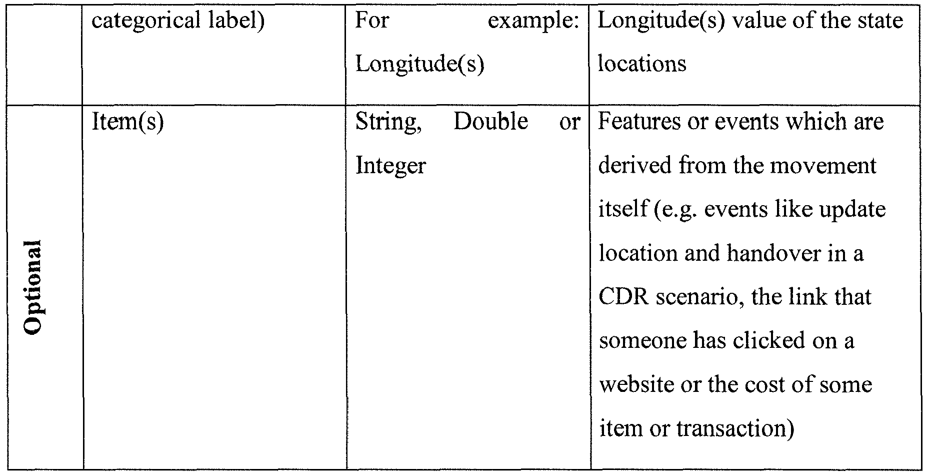

### Creating a New Model Based on Input Data

This section describes the process of training a new synthetization model based on real data. The complete process is depicted in Figure 1. The steps are exemplarily explained with taking an example data set of the NYC Taxi data.

### Preprocessing

It is assumed that the data is already in the format as described above.

Before the modelling starts, the input data is transformed to perform object tracking for modelling, resulting in the creation of two new columns as can be seen in the below table:
1) All Transactions, are cleaned in order to remove any empty or outlier data entries. For example in the case of the NYC dataset, spurious coordinates in the middle of the Atlantic are removed by rejecting records beyond a bounding box around the greater NY area.
2) Each Transaction receives a unique TransactionID
3) Sequences of Transactions for a given ObjectID are split into multiple Sessions to make them manageable and clusterable. For the taxi dataset for example, sequences are split if the time delay between two Transactions is particularly long. (> 3 * *average waiting time for ObjectID*). This information is added via an additional column SessionID. Each SessionID is unique and contains various TransactionIDs as shown below.

| **OID** | ***Session* ID** | ***Transaction* ... ID** | | **State (From)** | | **State (To)** | | **Item(s)** |
|---|---|---|---|---|---|---|---|---|
| | | | | **Lat** | **Long** | **Lat** | **Long** | |
| 1 | 1 | 1 | ... | 40.88 | -73.92 | 40.87 | -73.88 | ... |
| 1 | 1 | 2 | ... | 40.74 | -74.00 | 40.85 | -73.96 | ... |
| 1 | 1 | 3 | ... | 40.78 | -73.93 | 40.78 | -73.81 | ... |
| 1 | 2 | 4 | ... | 40.87 | -73.91 | 40.87 | -73.89 | ... |
| 1 | 2 | 5 | ... | 40.74 | -73.99 | 40.85 | -73.96 | ... |
| 1 | 2 | 6 | ... | 40.78 | -73.93 | 40.77 | -73.81 | ... |

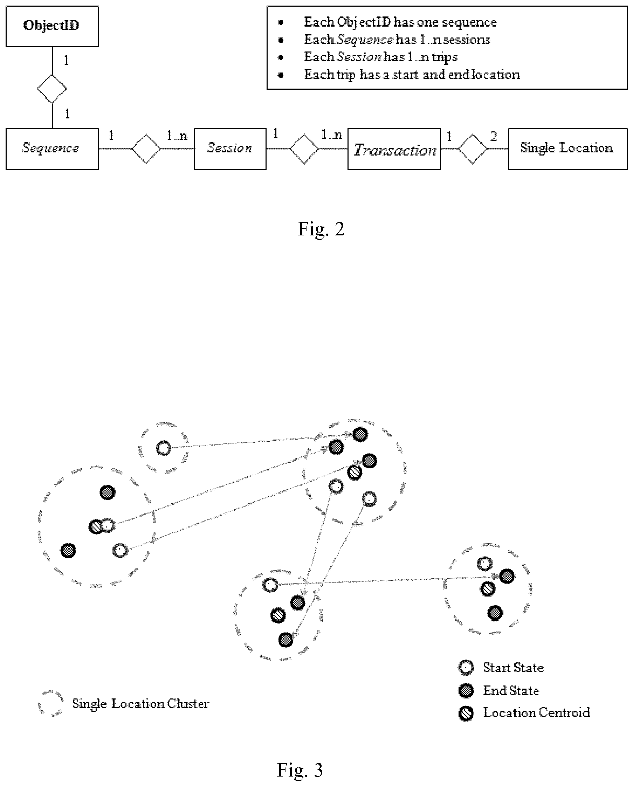

By adding the SessionID, state transitions are modelled in a 4 -level hierarchy as depicted in Figure 2.

### Hierarchical Transition Clustering

Main objective of this step is to compress the "Big Data"-Input into a compact representation (clusters) of the core characteristics needed to allow efficient statistical modelling of the data in the later stages of the algorithm.

As described above, transitions occur at 4 hierarchical levels: Sequences → Sessions → Transactions → States(Locations).

In order to best represent such a hierarchy, the data are clustered bottom-up, beginning with the States (locations) and ending at Session level. Sequences are not currently clustered as they are expected to be too different and do not lend themselves to clustering.

Single State(Location) Clustering (First Hierarchy Level). Please note that it is interchangeably referred to the generic concept of State clustering with the term Location clustering.

The Location Clustering step aims at grouping single locations of interest and thereby improving a network structure onto the data. This helps in clustering the Transactions. An exemplary sketch of the single location clustering can be seen in Figure 3.

All single locations (Latitude and Longitude coordinates) are extracted to form a n x 2 feature matrix. Subsequently, a k-means heuristic is used to cluster all single locations into similar groups. Thereby, the Euclidian distance is used as a distance measure. The resulting centroids are added to each location of the Transactions as depicted in the below table. In the next clustering stage (Transaction clustering), those newly created single location centroids will be used to find Transaction clusters.

| **OID** | ***Session* ID** | ***Transaction* ID** | **...** | **StateLat(s)** | **StateLong(s)** | **Item(s)** | **StateLat(s) Centroid** | **StateLong(s) Centroid** |
|---|---|---|---|---|---|---|---|---|
| 1 | 1 | 1 | ... | 40.88 | -73.88 | ··· | ··· | ··· |
| 1 | 1 | 2 | ... | 40.74 | -73.96 | ··· | ··· | ··· |
| 1 | 1 | 3 | ... | 40.78 | -73.81 | ··· | ··· | ··· |
| 1 | 2 | 4 | ... | 40.87 | -73.89 | ... | ··· | ··· |
| 1 | 2 | 5 | ... | 40.74 | -73.96 | ... | ··· | ··· |
| 1 | 2 | 6 | ··· | 40.78 | -73.81 | ... | ··· | ··· |

Preferably, the parameter k is determined using at least one of the following metrics: BIC, AIC or the Gab Statistic. An example of gab statistic can be found in ref. [3].

Preferably, all metrics need to perform k-means repeatedly.

### Trip Clustering (Second Hierarchy Level)

In the previous clustering stage, single locations were clustered together. In this stage, similar Transactions are being clustered to allow compression and modelling of Transaction information.

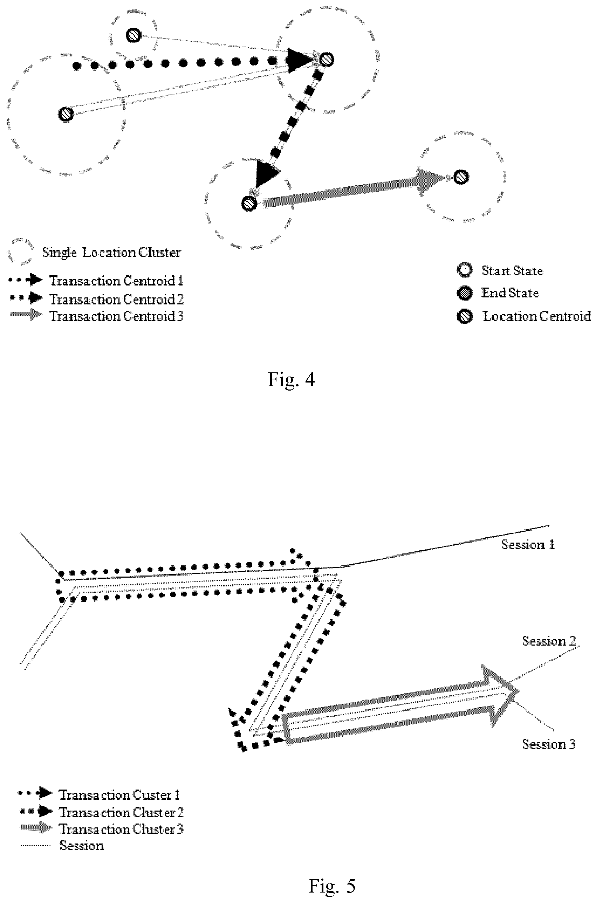

Instead of using the raw real data locations, the single location centroids are used to represent Transactions. This helps in creating connected Transaction clusters as depicted in Figure 4 that resemble a network structure, if visualized. When coming to the Session modelling phase below, each node of the Markov Chain represents a Transaction cluster. In this embodiment, the employed clustering method is k-means and the distance measure is the Euclidian distance. The feature matrix for k-means is a n x 4 matrix with each row containing the columns: FromLatCenter, FromLongCenter, ToLatCenter, ToLongCenter as shown in the below table. The resulting trip cluster IDs are added as an additional column to the table structure.

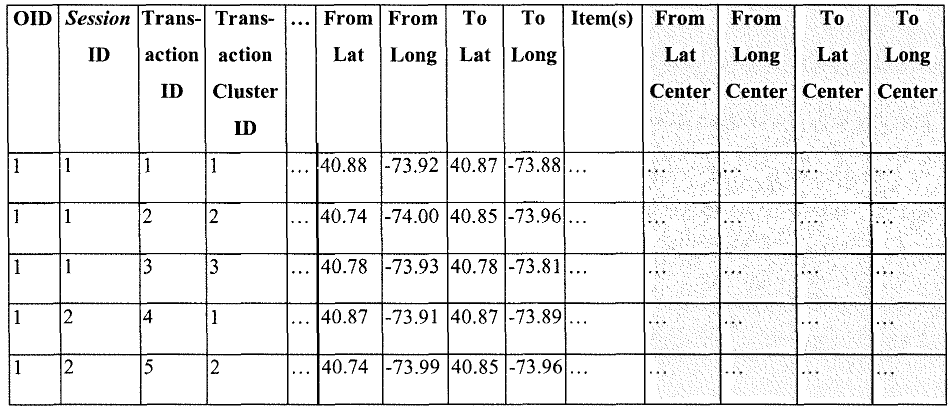

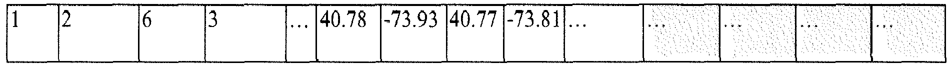

Preferably, the parameter ***k*** is determined using at least one of the following metrics: *BIC, AIC* or the *Gab Statistic*.

Preferably, all metrics need to perform k-means repeatedly.

### Session Clustering (Third Hierarchy Level)

As discussed in above, sequences were split into Sessions to make movements clusterable. One of the motivations is that shorter movement patterns lend themselves better to clustering because patterns might become visible.

Following the Location Modelling, in the Session Modelling phase below, each cluster of Sessions will be transformed into a Markov Chain Model modelling movements and items. Figure 5 shows an exemplary sketch of session clustering according to an embodiment of the present invention.

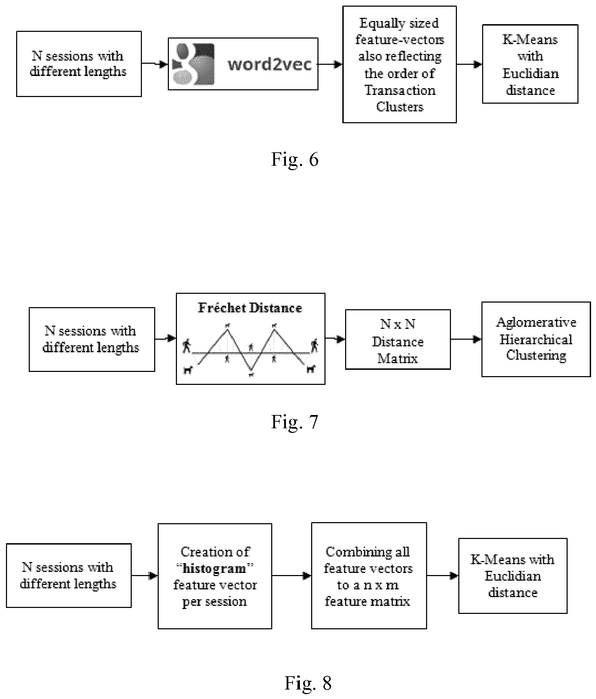

While testing different approaches of clustering Sessions, three ideas will be presented in the following, each resulting in an additional column SessionClusterID as shown in the below table:
- Creation of a feature matrix using Word2Vec and then clustering it using k-means with Euclidian distance. Internally, Word2Vec uses an artificial neural network to create equally sized feature vectors for each Session also taking the order of trips clusters into consideration. Figure 6 shows an exemplary sketch of clustering the sessions of respective state transitions clusters into a plurality of session clusters using the word2vec tool according to an embodiment of the present invention.
- Using the Transaction centroids as a *n x* 4 feature matrix and then using Fréchet Distance to calculate the distance between Sessions. Afterwards agglomerative hierarchical clustering is used to find similar groups. Figure 7 shows an exemplary sketch of clustering the sessions of respective state transitions clusters into a plurality of session clusters using the Fréchet-Distance to measure the distance between sessions.
- While the Word2Vec and Fréchet-Distance approach both take the order of the visited Transaction clusters into consideration, it is also possible to neglect the order. This approach is called the "histogram approach". To perform this kind of clustering, all possible Transaction clusters represent all possible features that a Session might have. Now, for each Session it is counted how many times a certain Transaction cluster appears and is added to its feature vector. If one Transaction cluster has a value of 1, it means that is has appeared once in the Session. If all feature vectors have been created, k-means can be used to cluster the Sessions using Euclidian distance. Figure 8 shows an exemplary sketch of clustering the sessions of respective state transitions clusters into a plurality of session clusters using the "histogram"-approach.

Compared to the previous clustering stages the Session clustering is the most difficult stage. While again it is difficult to determine the right k, this stage has various pitfalls to overcome:
- Comparing two *Sessions* is more complex task than comparing two *Transaction* or two locations. This can drastically increase the time complexity of the algorithm. E.g. using the Fréchet Distance, it took 8 hours to compare all *Sessions* with each other on an 8 Core machine with 32 GB RAM with fully parallelized code.
- Using the Word2Vec approach is much faster compared to the Fréchet Distance (5 min. vs. 8 hours).
- If the *Sessions* would have equal length, it would be possible to perform a simple k-means clustering. To circumvent this problem, one can use the Fréchet distance, the Word2Vec approach or the already mentioned "histogram" approach.

| **OID** | ***Session* ID** | **Transaction ID** | **Transaction Cluster ID** | ***Sessions* Cluster ID** | **···** | **From Lat** | **From Long** | **To Lat** | **To Long** | **Item(s)** | **From Lat Center** | **From Long Center** | **To Lat Center** | **To Long Center** |
|---|---|---|---|---|---|---|---|---|---|---|---|---|---|---|
| 1 | 1 | 1 | 1 | 1 | ··· | 40.88 | -73.92 | 40.87 | -73.88 | ··· | ··· | ··· | ··· | ··· |
| 1 | 1 | 2 | 2 | 1 | ··· | 40.74 | -74.00 | 40.85 | -73.96 | ··· | ··· | ··· | ··· | ··· |
| 1 | 1 | 3 | 3 | 1 | ··· | 40.78 | -73.93 | 40.78 | -73.81 | ··· | ··· | ··· | ··· | ··· |
| 1 | 2 | 4 | 1 | 1 | ··· | 40.87 | -73.91 | 40.87 | -73.89 | ··· | ··· | ··· | ··· | ··· |
| 1 | 2 | 5 | 2 | 1 | ··· | 40.74 | -73.99 | 40.85 | -73.96 | ··· | ··· | ··· | ··· | ··· |
| 1 | 2 | 6 | 3 | 1 | ··· | 40.78 | -73.93 | 40.77 | -73.81 | ··· | ··· | ··· | ··· | ··· |

### Session Modelling

In the location modelling stages, the aim was to compress data to its statistical core characteristics by finding groups of similar behaviour on different hierarchical levels of movements (Single Locations, Transactions, Sessions and Sequences).

### Scope of the Session Modelling Stage

The Session Modelling stage aims at modelling movement on the Session level, which is the transition from Transaction cluster to Transaction cluster. As described above, Sessions were the result of splitting long sequences into multiple smaller parts to improve clustering results. The question of which Sessions are performed after one another will be modelled in the sequence modelling stage below.

### Implementation

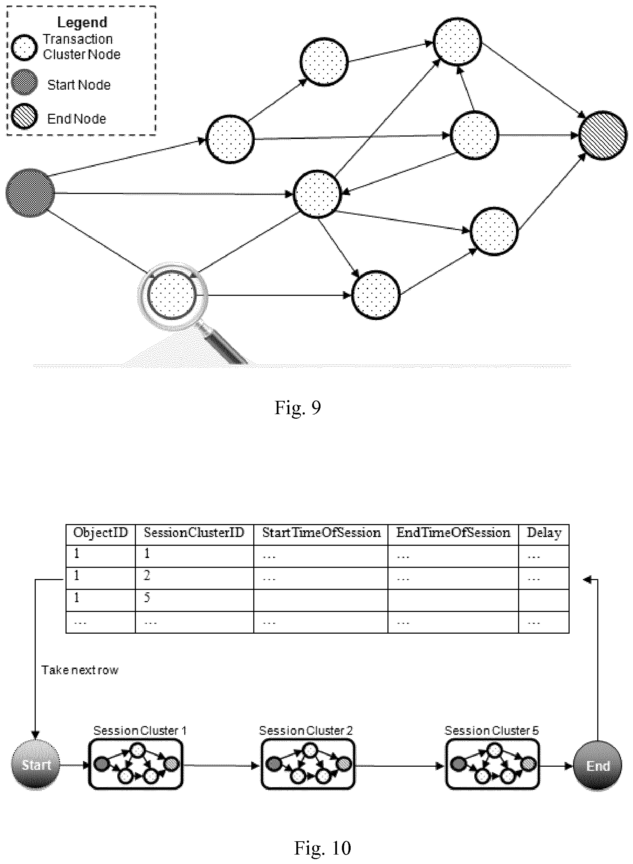

The concept in this embodiment is to use the concept of Markov Chains to model transitions between Transaction clusters, however extended with additional machine learning models to allow the incorporation of all influencing factors that lead to a certain transition and the generation of items. The prototypical implementation of the extended Markov Chain model contains 4 top level elements: Standard nodes, Edges between nodes, Starting nodes and end nodes. Standard nodes itself represent Transaction clusters and contain further predictive models as can be seen in Figure 9.

In Figure 9, every Transaction Cluster Node represents a transaction Cluster and comprises:
1) All IDs of successors & predecessors including transition probabilities;
2) Access to a Bayesian Network for predicting transaction delays trained on information about current & previous Transaction Cluster;
3) Access to Bayesian network for item generation training on current Transaction Cluster.

Every Markov Chain models one Session cluster. It comprises of 1 start node, 1 end node, an arbitrary number of standard nodes, each representing a Transaction cluster and transition probabilities between those nodes, as can be seen in Figure 9.

Transaction Cluster nodes of one Markov Chain (or Session) can also appear again in other Markov Chains that are representing other Session clusters.

The start node is the entry point into the Markov Chain and allows sampling the first Transaction Cluster for the Session from its transition probabilities. The start node itself is not connected to any Transaction cluster.

Similarly, the end node is not connected to any Transaction Cluster. Once, the end node is reached, a Session has ended. Each node contains various elements which altogether form the extended Markov Chain implementation used.

Successors and Predecessors. Each node contains a list of its possible successors and predecessors including their transition probabilities. However, according to this embodiment, the predecessor list of the start node is empty. Reversed, according to this embodiment, the successor list of the end node is empty. The transition probabilities are, in this embodiment, calculated by counting frequencies and then building the empirical cumulative distribution function from the results. Successors are sampled using the method of inverse transformation sampling. However, other embodiments could consider conditional probabilities to be computed based on previously visited transaction clusters, for example.

Bayesian Networks for Transaction Delay Prediction. Each Transaction Cluster Node of a Markov Chain has preferably access to a Bayesian network to predict the delay time until the next Transaction is performed. The Bayesian network is trained on the current and all previous Transaction Clusters if they are existing. Different Markov Chains might be able to access the same Bayesian Network Objects if they contain the same trip clusters.

Bayesian Network for Item Generation. Each Transaction Cluster Node of a Markov Chain has access to a Bayesian Network that allows predicting the items for the current Transaction Cluster. In the case of a taxi trip, items could be the tip a passenger has given, the costs, the duration of the trip and/or the distance. Different Markov Chains can access the same Bayesian Network Objects if they contain the same Transaction clusters.

In the following all main challenges encountered during the development are discussed:
- Preferably, the R-Package used for the Bayesian Networks is BNLearn.
- Preferably, when using the BNLearn-Package, the resulting predictions are of linear nature. In other words, preferably, when using the BNLearn-Package linear relationships between variables are modelled.
- Preferably, currently domain knowledge is used to model the possible relationships between variables in the Bayesian networks.
- Preferably, items are not modelled based on the past. In other words, past items do not influence current items. Preferably, delays between Transactions are only based on the previous Transaction.
- Preferably, transitions from Transaction cluster to Transaction cluster are modelled using frequency counting. In other words, preferably, current or past items do not influence the next Transaction cluster.
- The sequential calculation/generation of the Transaction duration and delay time between Transactions might lead to a propagation of time, so that Sessions could last for days or begin in distant future. Therefore, preferably two further constraints can be implemented to restrict the number of Transactions per Session: First, a time constraint can be added which displays the last starting time of Transaction. Second, the maximum number of Transactions for a certain Session can be restricted by a Bayesian network that predicts/determines the number based on the number of Transactions for a specified Session Cluster.

### Sequence Modelling

While in the Session, modelling stage the aim is to model transitions within a Session cluster, this section combines multiple Sessions into a single sequence which will belong to a single Object ID.

In order to do so, the real clustered data is used to build a table containing one Session cluster per row belonging to an ObjectID, with its start time, end time and delay time to the next Session. This table is then used to train a Bayesian Network that learns the relations between ObjectIDs, SessionClusterID, start time, end time and delay to the next SessionCluster. Subsequently, this Bayesian Network is used to produce a table of synthetic data containing similar information. This table is then used to create sequences of Sessions for an ObjectID in the synthesis process.

Figure 10 shows an exemplary sketch of the general concept of sequence modelling.

Preferably, the end time of a Session is integrated in the prediction of the delay between Transactions.

With low probabilities, sequences can last for a long time and end in the far future. Therefore, preferably, manual constraints are added to prevent these sequences.

### Fabricating Synthetic Data based on Model

This section relates to the process of fabricating synthetic data based on a training model. The complete process is shown in Figure 12.

### Implementation

According to this embodiment, the process starts by loading a list of serialized R-Objects that contain all information needed to synthesize data.

Next the user specifies the total number of Sessions to be generated. As a result, based on a trained Bayesian Network, a table is generated as shown in the below table:

| **ObjectID** | ***Session*ClusterID** | **StartTimeOf*Session*** | **EndTimeOf*Session*** | **Delay** |
|---|---|---|---|---|
| 1 | 1 | ··· | ··· | ··· |
| 1 | 2 | ··· | ··· | ··· |
| 1 | 3 | ··· | ··· | ··· |
| 2 | 3 | ··· | ··· | ··· |
| 2 | 5 | ··· | ··· | ··· |
| 3 | 2 | ··· | ··· | ··· |
| ··· | ··· | ··· | ··· | ··· |

The table contains n rows, each having an ObjectID, SessionClusterID, StartTimeOfSession, EndTimeOfSession and a Delay time. Each row represents the top level description of a single Session that will be generated as part of the synthesis:
- To which ObjectID does this Session belong?
- In which Session cluster does the Session take place?
- At what time does the Session start?
- How much time is needed to pass until this Session can start?

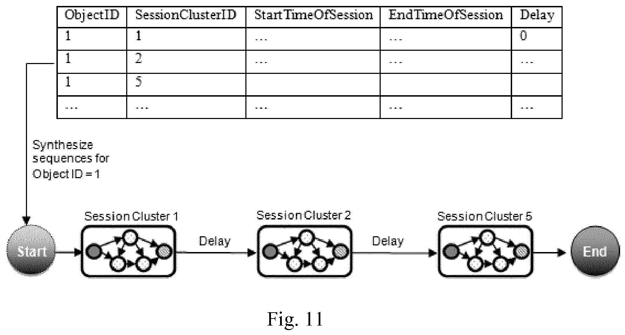

Next, the table is split based on Object IDs. Thereby, each resulting table per Object ID represents a sequence of Sessions Clusters that will be part of the synthesis. As depicted in Figure 11, the exemplary ObjectID = 1 will visit Session Cluster 1, 2 and 5 after another. According to this embodiment, the first Session of a sequence always has a delay of zero, as there is no previous Session available.

In the course of the synthesis for each ObjectID, each Markov Chain Model for each predicted Session Cluster is loaded and traversed according to its trained properties. Thereby, items and delays between Transactions are generated using the trained Bayesian Networks for each Transactions Cluster as can be seen in Figure 12.

As described above, the entry point to a Markov Chain is its starting node. It is traversed according to its transition probabilities, until the end node has been reached, the last starting time for a Transaction is reached, or the maximum number of Transactions for that Session Cluster is achieved.

If one Session has ended, the predicted delay time from the ObjectID table, as shown in the above table, is used to calculate the first starting time of the next Session.

Preferably, the resulting synthetic data table contains one row per Transaction and preferably has the same format as the input data.

### Examples

The presented invention has been evaluated on the New York Taxi Data Set and an extract of Call Data Records coming from the mobile network of Telekom.

### Data

The used New York Taxi data set includes 30 GB of single taxi trips for the year 2013, each row of data containing at least the following information: Medallion; hack_licence; Pickup_Datetime; Pickup_latitude; Pickup_Longitude; dropoff_datetime; dropoff_latitude; dropoff_longitude; trip_distance; trip_time_in_secs; surcharge; fare_amount; tip_amount; total_amount. The New York Taxi Data Set 2013 is retrievable from: http://www.andresmh.com/nyctaxitrips/

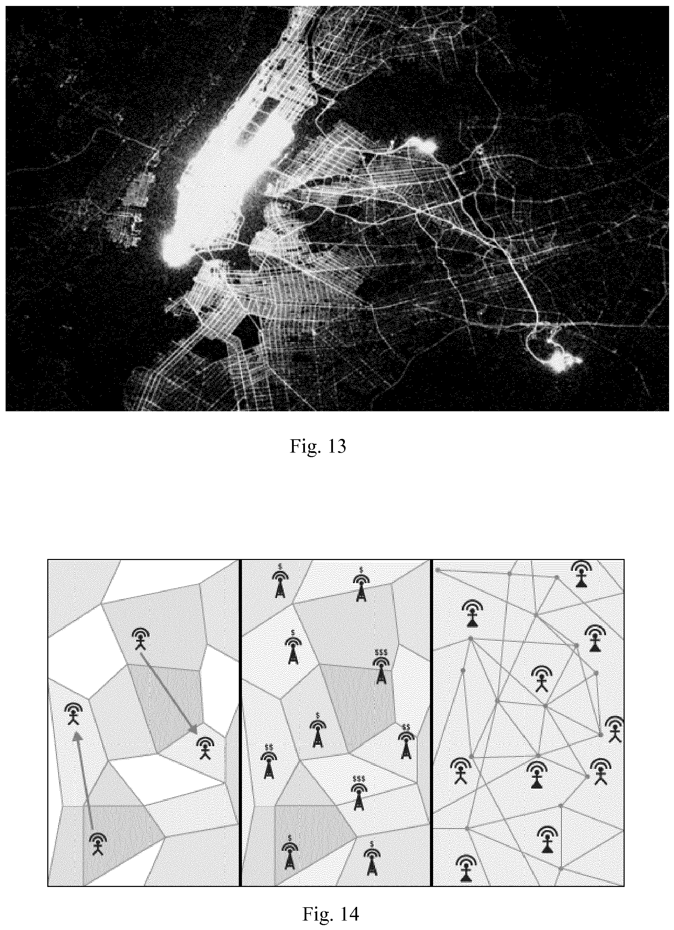

A visualization of all pickup and drop-off locations is depicted in Figure 13.

The second type of data comprises different extracts of Call Data Records coming from the mobile network of Deutsche Telekom. Each row of data contains a single event that happened when a mobile phone signal was handled by tower, as can be seen in Figure 14.

Thereby, each row contains the following information: ObjectID; StateID; Timestamp; Item. The ObjectID represents the individual using the phone, the StateID represents the tower to which a connection was established, the Timestamp contains the time at which it happened and the Item contains the type of event that has happened (e.g. handover).

### Technologies

Two development technologies can be used: Spark and R. Spark are preferably used for the first half of the algorithm, which comprises the Location and Movement.

R is used in this embodiment for the subsequent stages, which are Session Modelling, Sequence Modelling and finally the fabrication of synthetic data. However, also other languages like SCALA or Python on a parallel platform like Spark would be preferred.

The visual analysis of the results can be performed using Tableau, as it allows an interactive analysis of geo spatial data. Static visual analyses can be performed in R.

### Reasoning for combination R and Spark

R is a scientific scripting language intentionally designed for statistics. Therefore, its language natively contains constructs helpful for statistical analysis. Also, it allows an interactive analysis of data without the need of continuous recompiling of code. It is suitable for quick and dirty "data wrangling", testing of ideas and offers an immense amount of different statistical packages.

On the downside, R is not developed with multi-core or production quality systems in mind. Hence, speed parallelization capabilities and stability are not always sufficient. Also memory management is inefficient and can lead to unnecessary consumption of RAM. Further, it is not natively Object Oriented.

Spark is a fast and general processing engine compatible with Hadoop data. It can run in Hadoop clusters through YARN or Spark's standalone mode, and it can process data in HDFS, HBase, Cassandra, Hive, and any Hadoop InputFormat. It is designed to perform both batch processing (similar to MapReduce) and new workloads like streaming, interactive queries, and machine learning. On the positive side Spark is the currently fasted Big Data processing system and is intended for multi-core and multi-cluster systems. Also it is intended for the development of production ready systems which are stable and maintainable.

Further, it has a more efficient memory management than R. For every execution, the complete code is compiled. That makes it fast. Spark is written using the Object Oriented Programming Language Scala. However, it is also possible to write applications using Java or Python. Scala is preferred as it is the easiest and most direct way to develop Spark applications. On the downside, interactive analysis and quick and dirty testing of ideas are not as easy as with R.

Also, due to the novelty of Spark it does currently only offer very few statistical libraries. Further, the employed map reduce paradigm can reduce the development speed, if the developer is not used to it.

Hence, it is preferred to first use an interactive and rich tool like R, for the verification and testing of new ideas. Once a part of the pipeline is verified and fully understood, it is preferably realized in SCALA or Python on a parallel platform like Spark.

The present invention is applied and tested on two data sets: First, an extract of the free available Taxi Data from New York City (downloadable at http://www.andresmh.com/nyctaxitrips/) is used to develop and test the implementation of the invention.

The Telekom-owned CDR data serves as a second test data set. This chapter describes the used data sets, and compares the original data to the results of synthesis.

### New York City Taxi Data

In the raw NYC Taxi data the information of one trip is divided into two different files - one containing the trip data, the other containing the trip fares. These two files are merged to get the necessary data structure for the algorithm.

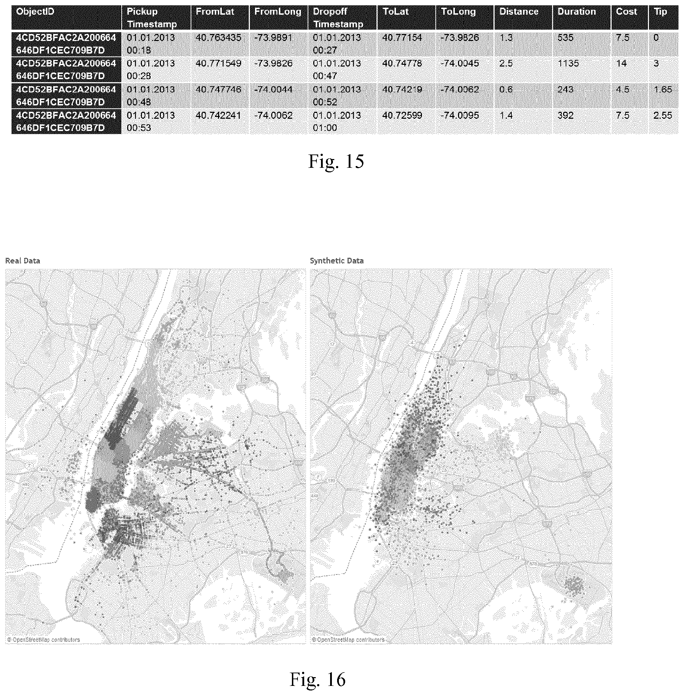

The used input file for the algorithm is depicted in Figure 15.

A row represents a trip or - as called in the algorithm - a transaction between two locations. The ObjectID is an alpha-numeric String which represents a pseudonymization of the taxi driver. The PickupTimestamp represents the date and time of the trip start, and the DropoffTimestamp presents the ending of a trip. During the algorithm the time is converted into a UNIX timestamp to facilitate the processing. FromLat and FromLong are the coordinates of the pickup location of the taxi, analogously ToLat and ToLong being the coordinates of the drop-off location.

The Distance of a trip, respectively between pickup and drop-off is given in miles, the Duration is displayed in seconds. Cost and Tip are represented in US-Dollars. Within the data Tips are only reported for credit card transactions. Cash tips are not included. The columns FromLat, FromLong, ToLat and ToLong represent the state/location information. Distance, Cost and Tip belong to the items of the transaction.

Some results of the comparison of real clustered data and the synthesized data are shown in Figure 16. The input data consists of 411,385 transactions. The clustering was conducted using 400 location clusters, 200 transaction clusters, and 100 session clusters. As output, 595 sessions were synthesized, containing 6,621 transactions in total. Figure 16 depicts the pickup locations of the real clustered data and the synthetic data. The memberships to the same transaction cluster are shown in Figure 16.

In the synthetic data, similar patterns of the clustered locations are visible. But a higher number of sessions, resp. transaction, can improve the similarity of both data sets regarding the pickup locations. Furthermore, a higher number of clusters can result in a more precise location synthesis.

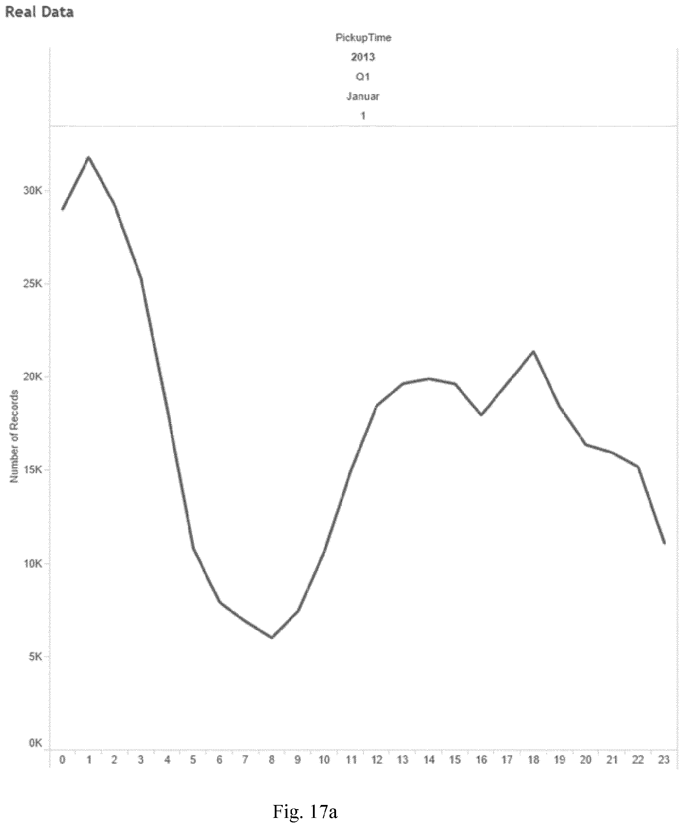

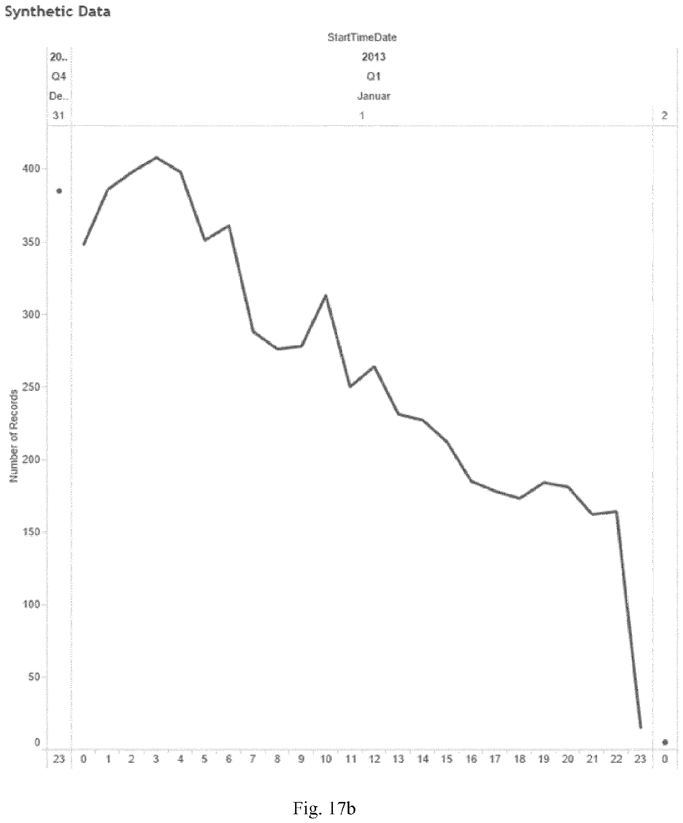

Comparing the pickup times of the real and synthesize data an almost equal period could be achieved as can be seen in Figures 17a and 17b. Moreover, both data sets have a peak in the night of the 1 st January 2013 between 1 and 3 a.m.

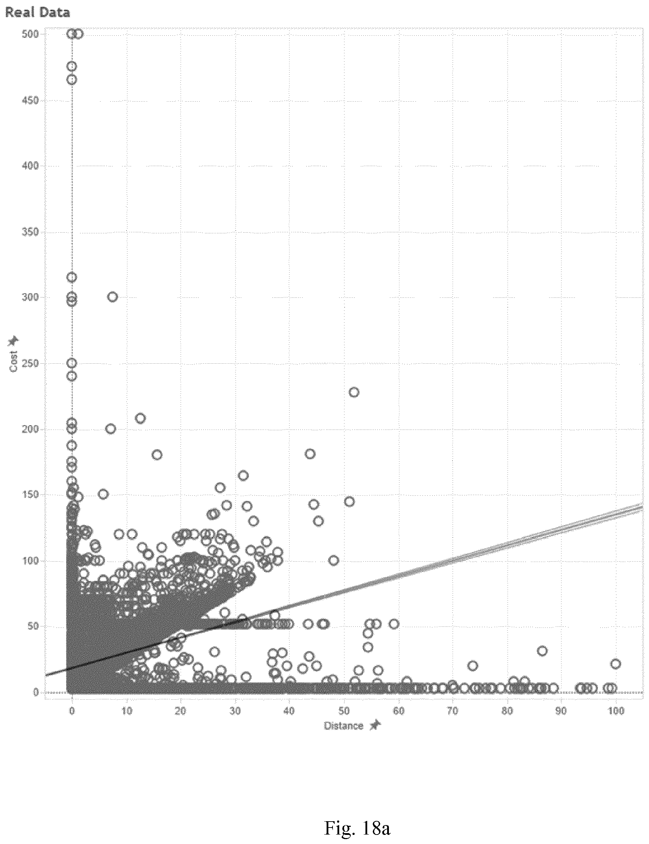

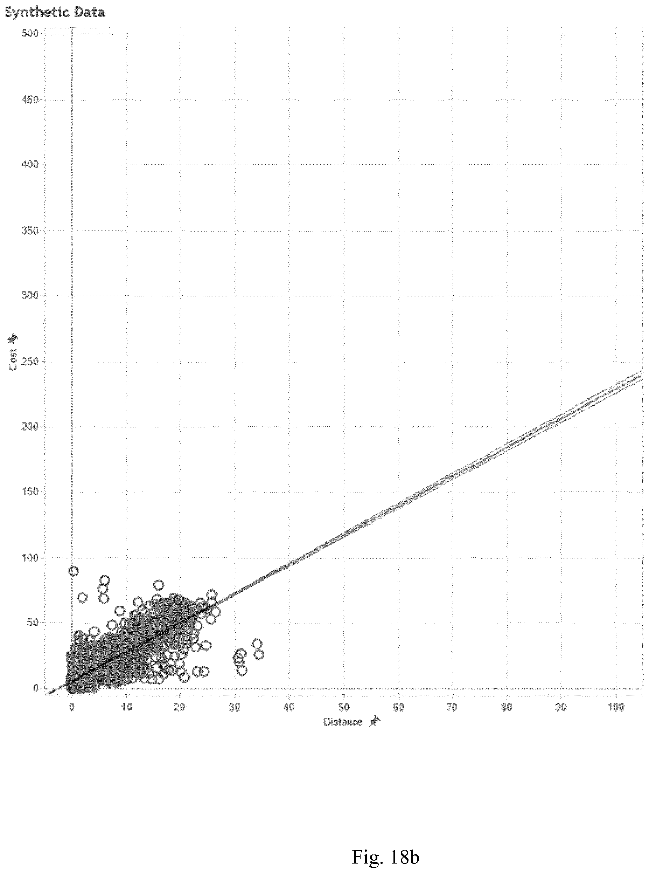

Figures 18a and 18b illustrate the relationship between Distance and Costs in both data sets. Already in the real data there are some extraordinary values, e.g. high distances for a price of zero, or high costs for a very small driven distance. These values can be categorized as technical outliers. Because of their small likelihood (compared to other values) they are not represented in the synthetic data.

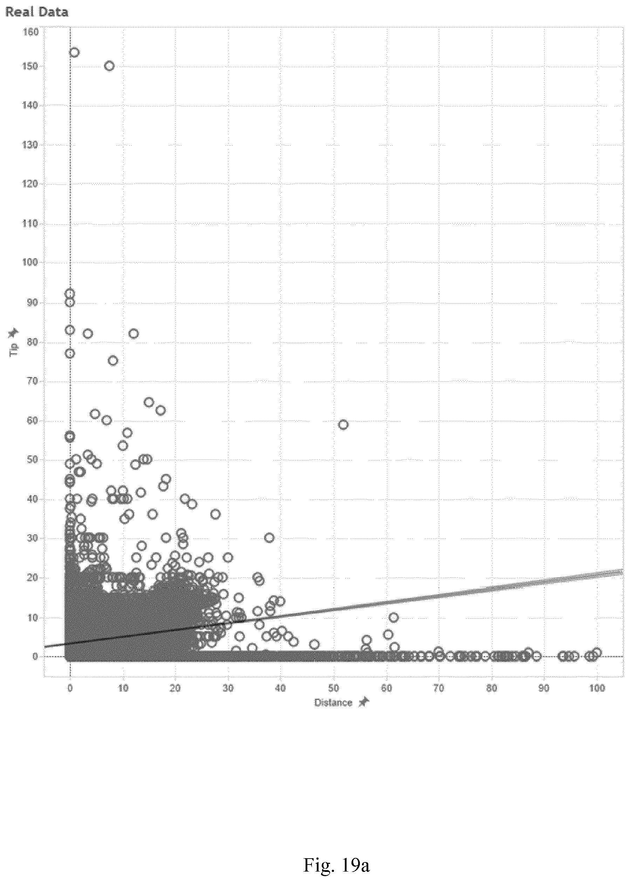

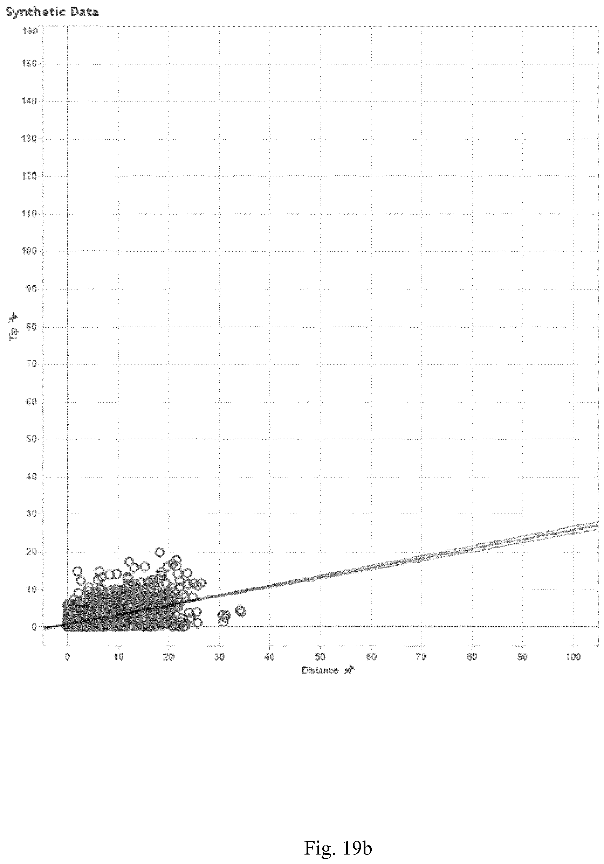

The relationship between Distance and Tip is represented in Figures 19a and 19b. As mentioned above tips are only reported for credit card transactions that results in a high number of $0 for tip values in the real data. These are partly represented in the synthetic data, but mostly for shorter distances. A good result is the very similar trend line of both data sets which depicts a slide increase of tip for longer distances of taxi trips.

### CDR Data

The CDR Data contains call data records from cell towers, in practice information about when and from where a SMS was sent. For testing purpose the data of 15 minutes is provided and transformed to the necessary algorithm data structure.

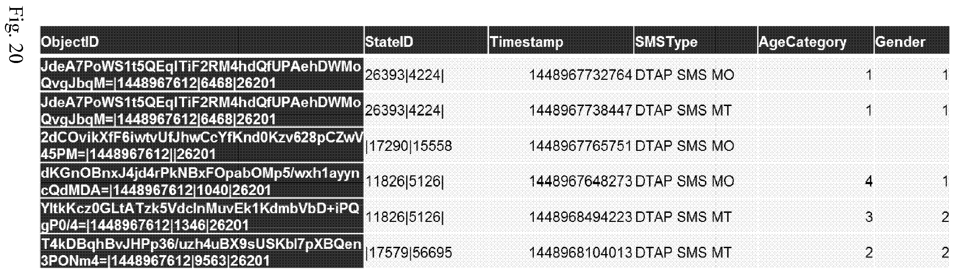

An extract of the used data structure is depicted in Figure 20. The ObjectID is an alpha-numeric String referring to a person using his mobile phone. Other person-related information like the postal code is concatenated to the ObjectID (using pipe/vertical bar symbols).

The StateID represents an internal code for the location of the tower which is used as a categorical variable in this case. The Timestamp gives the UNIX Time (including Milliseconds) for the point in time of the event. However, there is no end time, the duration of the transaction is always zero. The SMSType displays the type of transaction. There are two different types. AgeCategory is a categorical value for an internal defined age group. Gender represents the Gender of the object. The last three variables belong to the items of the transaction. Furthermore, the last two columns contain missing values which have to be replaced (in this case with the value 0) for the modeling part (in order to create and use the Bayesian networks).

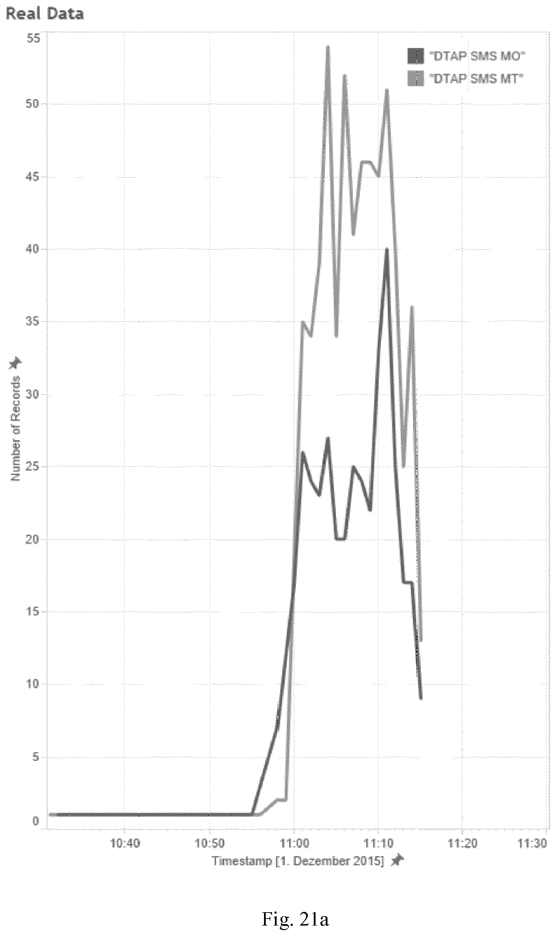

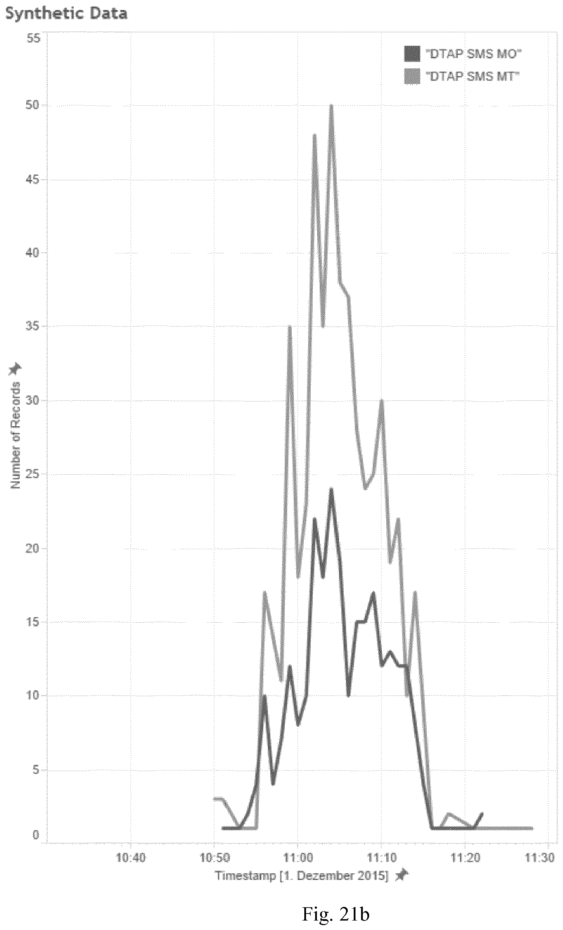

In the following, the results of the synthetic data are compared with the real CDR data. Figure 21 a and 21b show the number of CDR events in time divided by SMS type. For the SMS type "DTAP SMS MT" the progress looks quite similar.

The general behaviour is displayed in the synthetic data, e.g. including the peaks between 11:00 and 11:10 a.m.

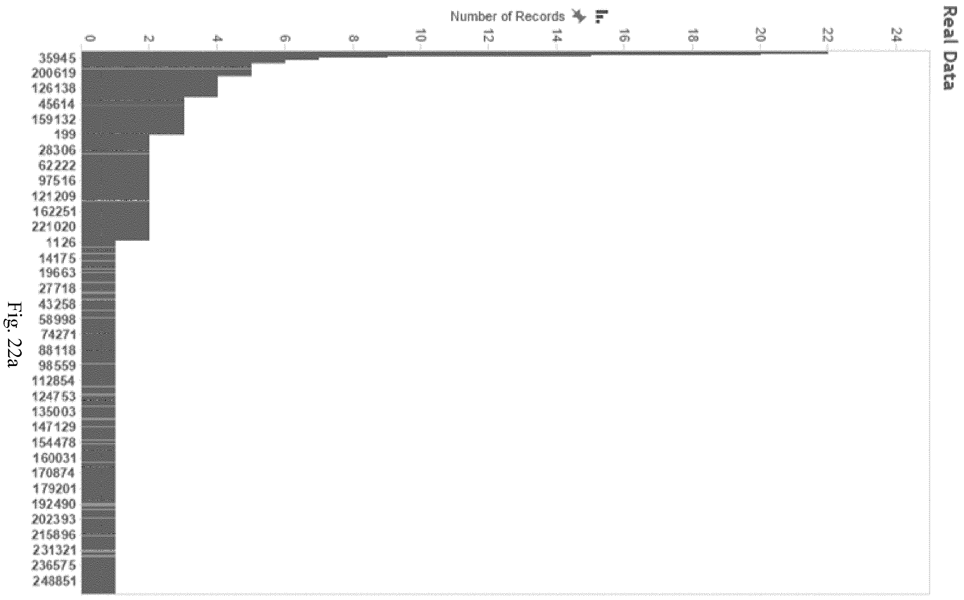

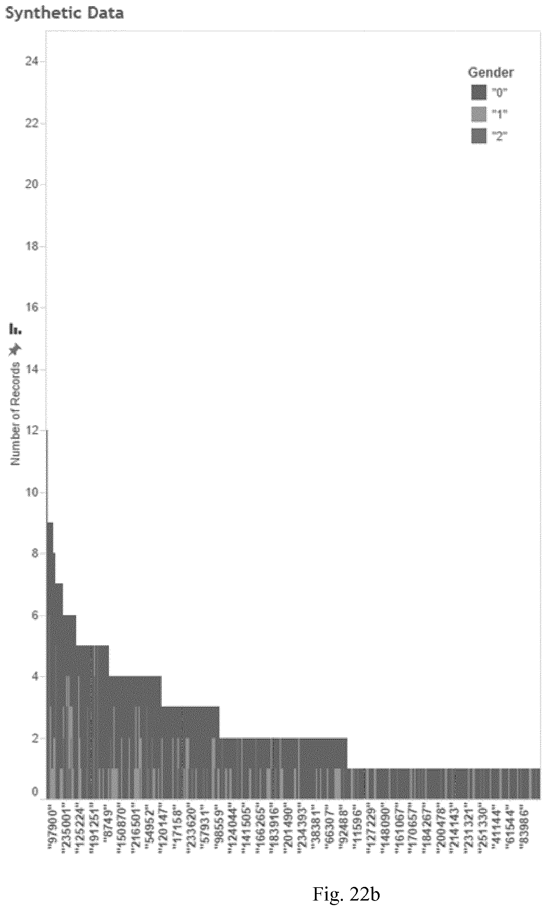

Comparing the synthesis and real data regarding the ObjectID as can be seen in Figures 22a and 22b, there are some differences: First, in the real data there is a small number of objects with a high number of transactions (e.g. greater than 10 or even 20) but the most part of objects have just one transaction. In contrast in the synthetic data there is one object with more than ten records. However a large part of the objects have between two and five transactions. About one third of the objects shows only one transaction. Another difference is the distribution of gender within one ObjectID. Of course an object can have just one gender what is also depicted in the left figure of the real data. Within the synthetic data the gender changes a lot between distinct transactions of the same object.

This issue can be addressed by modeling variables/items which belong to the object separately from the general item modeling and synthesis (where the items are assigned to a certain transaction).

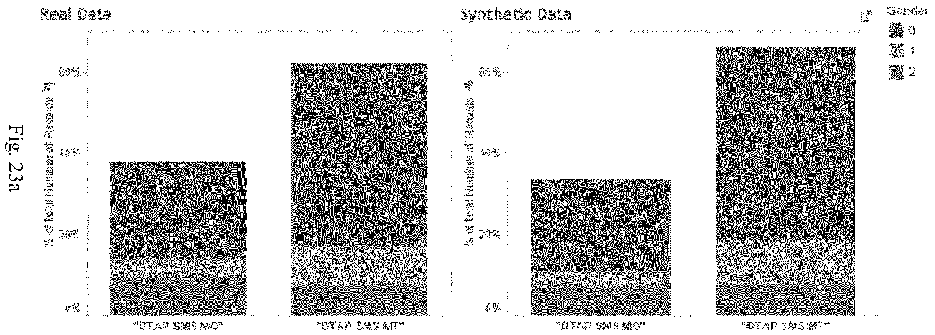

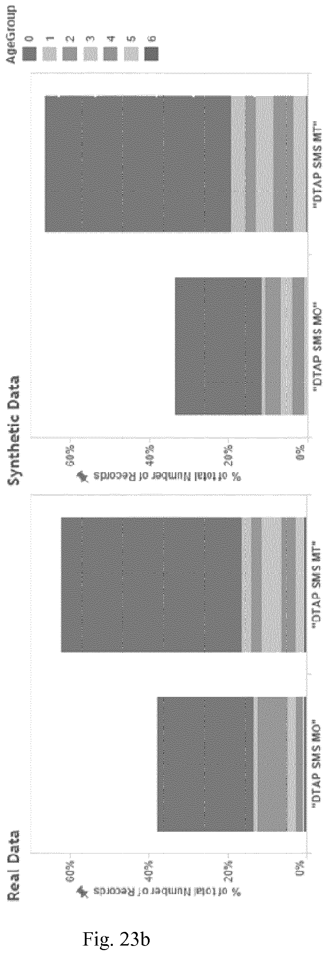

Figure 23a and 23b illustrate the differences of the SMS type divided by Gender and AgeGroup. The two diagrams on the top show a bar chart with a bar per SMS type. Different gender categories are shown. In total, the relative amount of each SMS type and gender within one SMS type of the synthesized data corresponds well to the distribution of the real data.

Considering the segmentation by AgeGroup, the SMS type "DTAP SMS MT" was better synthesized than the other one. The AgeGroup "2" has a smaller share in the synthetic data than in the real one. Furthermore, the AgeGroup "6" is not represented at all in the synthetic data.

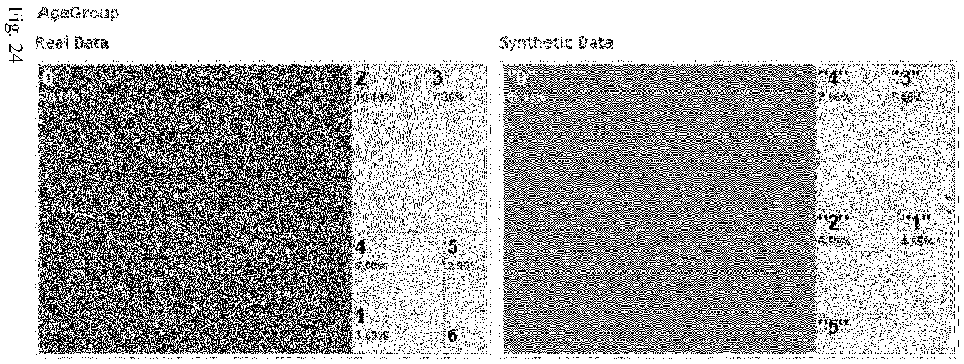

The second item in the data is the AgeGroup which represents a range of age for a certain object. The distribution of the age groups within the real and synthetic data is shown in Figure 24 by a tree map. The big numbers symbolize the age group of the item and the small number the percentage of transactions of that category within the data. As mentioned above (regarding the SMS type) there are some slight differences between the real and synthetic data distinguishable. For example, the AgeGroup "2" has a share of roughly 10 % in the real data. In the synthetic data this share decreases to 6.5 %.

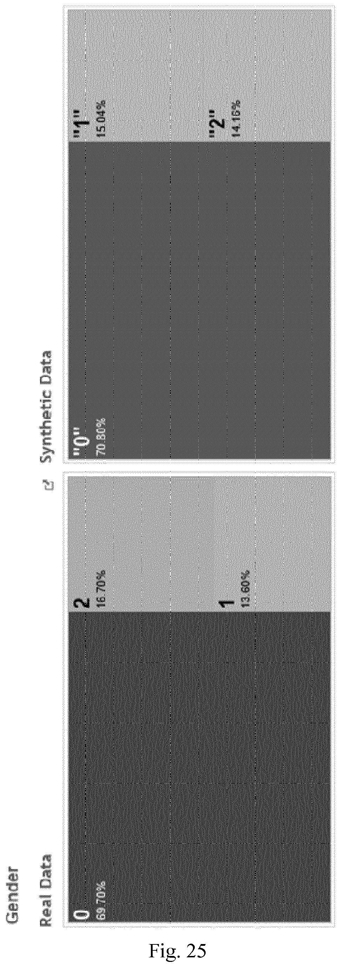

Considering Gender in the synthetic data, the relative amount throughout all transactions is comparable with the relative amounts within the real data, as can be seen in Figure 25.

During the development of the present invention, a group of general challenges have emerged that are addressed with the present invention.

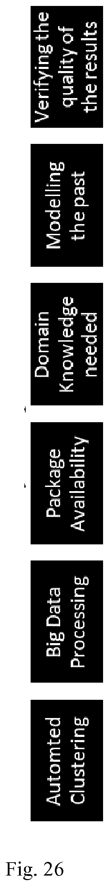

A summarization of those challenges is depicted in Figure 26.

### Automated Clustering

The chosen clustering algorithm is k-means. It is a heuristic approach for clustering data, which cannot guarantee the best cluster centers for a dataset as the initialization is random.

However, it is much faster compared to agglomerative hierarchical clustering which has a complexity of n².

In order to automatically determine a reasonable number of clusters for a given dataset, it is necessary to have some kind of metric that evaluates the goodness resp. quality of the clusters for varying number of clusters.

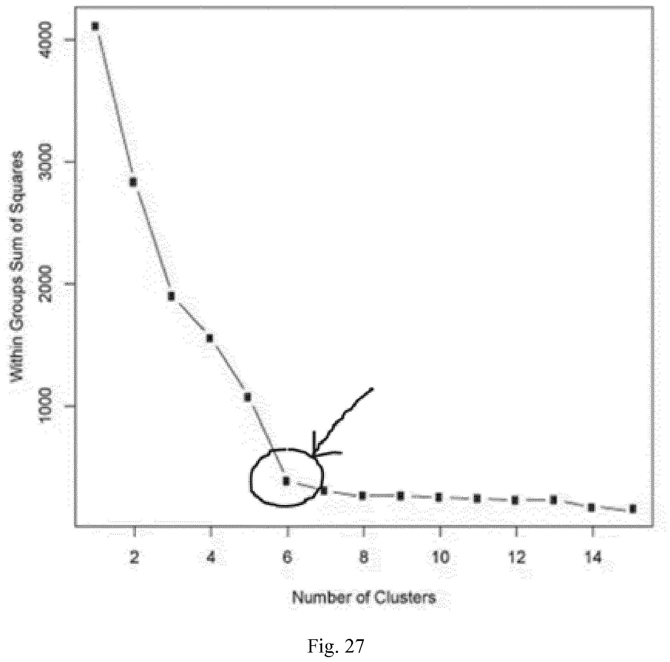

The so-called elbow approach is one proposal for finding the right k. An elbow diagram is shown in Figure 27.

### Domain Knowledge needed

Preferably, domain knowledge is used to model the possible relationships between variables in the Bayesian networks.

### Incorporating the past

Preferably, items are not modeled based on the past. That means past items do not influence current items. Preferably, delays between transactions are only based on the previous transaction.

### Constraints of Data Types

The present invention is capable of modeling data that is presented in terms of a flat table with no missing data values. If missing data exists, the data-mapper assigns a categorical label to it so that the core algorithms can process them seamlessly.

### Valid Data Types

Essentially categorical data, i.e. nominal and ordinal scaled data, is modeled.

All data, wherein the various variables (i.e. columns of the dataset) relates to a fixed set of predefined values/labels (either numeric or otherwise), can be processed and modeled by the present invention. Example of such categorical data is shown in the below table:

| ObjectID | Gender | Tax Level | PLZ | Age Group |
|---|---|---|---|---|
| A1201 | M | 1 | 10119 | Young |
| X1220 | F | 2 | 10115 | Mid-Aged |
| M13882 | F | 1 | 23882 | Old |

In contrast to such categorical data, *interval* or *ratio* data - which maps to real numbers, such as age, income, temperature, etc. can be dealt with.

Furthermore, no real models are developed to deal with such real valued variables. The following table contains both, categorical (ObjectID) as wells as interval/ratio variables. The Bayesian network and Decision trees can deal with such data but in a less efficient manner.

### Possible Extensions to Non-Categorical Data

As the present invention preferably uses categorical data, any real valued data can be quantized into a potentially 'large' set of bins (N bins), thereby making the data categorical (by falling into one of the N bins).
This can be done by the data-mapper that pre-processes data before transferring it over to the core methods that model and synthesize data.

### Tweaking the Clustering Phase of the Current System

Preferably, the present invention for data modeling and synthesis assumes one variable field (column of data) to be designated as a StateID that is alphanumeric and used for clustering the data.

The idea behind this clustering is on one hand breaking the data into meaningful similar data groups (clusters) while simultaneously reducing the size of data that (though similar) need to be processed individually.

According to an embodiment, generic multi-dimensional clustering approaches are used with a variety of distance metrics allowing for far greater flexibility. Preferably, all the real valued columns are designated jointly as a StateID (meant for clustering) label. A direct impact of this is that the columns lend themselves to meaningful clustering as shown in the below table:

| **Taxi ID** | **Dist** | **StartLong** | **StartLat** | **EndLong** | **EndLat** |
|---|---|---|---|---|---|
| 2010000001 | 14.05 | -73.948418 | 40.72459 | -73.92614 | 40.864761 |
| 2010000002 | 9.65 | -73.997414 | 40.736156 | -73.997833 | 40.736168 |
| 2010000003 | 1.63 | -73.967171 | 40.764236 | -73.956299 | 40.781261 |

This table shows a typical data set with real valued entries like location in latitude and longitude that can be used if the start and end locations were all used as one multi-dimensional StateID. Furthermore, Dist (distance) can be quantized and thereby made categorical.

### Constraints on Data Columns (variables)

Beyond the above constraints on what domains of data sets our method is suitable for, some additional constraints on the nature of data that can preferably be processed.

The datasets preferably comprises:
- Indexing via ObjectID: All data (categorical) preferably have at least one variable (column) that can be used as a key, based on which the dataset can be indexed. This 'key variable' is called the ObjectID. By defining a specific column to be the ObjectID, the method to perform data reformatting uses this variable as a key to collect all records that share the same ObjectID together.
- Chronology maintained via Time: It is preferred that the records have some sort of ordering enforced. Chronological ordering could be time or distance, (though usually it is time). Thus, there is preferably one variable that is designated as Time.
- Groupable variable via StateID: The present invention refers to grouping similar records together automatically and building statistics over such groups of data. This clustering is performed in order to reduce millions to a much smaller number of uniquely similar clusters.

### Constraints of Relationship Types

According to an embodiment, the present invention uses a state transition approach that groups (clusters) similar transitory behaviour and then model each of these "unique" clustered behaviours.

The core abilities of the present invention are, among others, to model interdependencies between variables at a given state based on current and previous states alone.

### Privacy Preservation

The exact details of how exactly privacy of users are further enforced and preserved as they are preferably not exactly detailed in terms of computational algorithms. Preferably, standard mechanisms to ensure privacy are implemented in the methods and systems of the present invention in terms of "k-anonymity" as well as preferably using approaches such as differential privacy.

While the invention has been illustrated and described in detail in the drawings and foregoing description, such illustrations and descriptions are to be considered illustrative or exemplary and non-restrictive; the invention is thus not limited to the disclosed embodiments. Variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality and may mean "at least one".

### List of references:

[1] - https://code.google.com/archive/p/word2vec/
[2] - Mikolov et al., Efficient Estimation of Word Representations in Vector Space; retrievable from arxiv: http://arxiv.org/pdf/1301.3781.pdf
[3]-https://datasciencelab.wordpress.com/2013/12/27/finding-the-k-in-k-means-clustering/

## Claims

1. Method for generating a training model for fabricating synthetic data comprising the steps of:
a) providing training data comprising information on a plurality of objects, the training data further comprising information on a plurality of states and state transitions of at least one object of the plurality of objects, the state transitions of the at least one object being chronologically ordered into a plurality of sessions;
b) clustering a plurality of states and/or a plurality of state clusters into a plurality of state transition clusters;
c) clustering the sessions of respective state transitions clusters into a plurality of session clusters;
d) modeling each session cluster using a stochastic process; and
e) training a probabilistic model using information on the respective object, the corresponding session clusters, start times of the corresponding sessions of the session cluster, the end times of the corresponding sessions of the session cluster and the delays between the corresponding session clusters.

2. Method according to claim 1, further comprising: clustering a plurality of states of respective objects into a plurality of state clusters after step a) and clustering the plurality of state clusters into a plurality of state transition clusters.

3. Method according to claim 1 or 2, wherein the stochastic process in step d) comprises a Markov Chain.

4. Method according to any of claims 1 to 3, wherein the probabilistic model in step e) comprises a Bayesian Network *tm*.

5. Method according to any of claims 1 to 4, further comprising at least one of the following steps before step a):
- removing empty data and/or removing outlier data from the training data;
- allocating a unique identifier *OID* to each object;
- allocating a unique identifier *TID* to each state transition;
- splitting at least one timely ordered sequence of state transitions into a plurality of sessions.

6. Method according to any of claims 1 to 5, wherein at least one constraint is introduced into the probabilistic model.

7. Method according to any of claims 1 to 6, wherein the clustering of the sessions of respective state transitions clusters into a plurality of session clusters in step d) is performed using the Fréchet-Distance to measure the distance between sessions.

8. Method according to any of claims 3 to 7, wherein at least one node of the Markov Chain represents a corresponding state transition cluster.

9. Method according to claim 8, wherein the at least one node is linked to a further Bayesian Network *im* for training to predict at least one item of the respective state transition cluster.

10. Method according to any of claims 8 or 9, wherein the at least one node is linked to a further Bayesian Network *dl* for training to predict the delay time until the subsequent state transition following the corresponding state transition cluster is performed.

11. Method according to any of claims 1 to 10, wherein at least one constraint is introduced into the stochastic process.

12. Method according to any of claims 2 to 11, wherein the clustering of the plurality of states of respective objects into a plurality of state clusters is performed using vector quantization, preferably using a k-means heuristic, more preferably using a k-means heuristic with Euclidian distance as a distance measure.

13. Method according to any of claims 1 to 11, wherein the clustering of the plurality of state clusters into a plurality of state transition clusters is performed using vector quantization, preferably using a k-means heuristic, more preferably using a k-means heuristic with Euclidian distance as a distance measure.

14. Method for fabricating synthetic data comprising using the method according to any of claims 1 to 13.

15. Method according to claim 14, comprising the following steps:
a) loading the trained probabilistic model;
b) inputting the number of sessions to be fabricated;
c) creating a table using a Bayesian Network, comprising at least one of the following information:
number and identity of objects in the respective cluster session;
start time and end time of the respective cluster session; and
d) loading the stochastic process for every object in every cluster session.

16. System for generating a training model for fabricating synthetic data using the method according to any of claims 1 to 13 and/or for fabricating synthetic data using the method according to claim 14 or 15.

17. A computer-readable medium containing program instructions for causing a computer to perform the method of any of claims 1 to 15.
